(19) Europäisches Patentamt
European Patent Office
Office européen des brevets

(11) **EP 4 811 666 A1**

(12) **EUROPEAN PATENT APPLICATION**

(43) Date of publication:
**23.09.2026 Bulletin 2026/39**

(21) Application number: **26165716.7**

(22) Date of filing: **18.03.2026**

(51) International Patent Classification (IPC):
***H03M 7/30*** *(2006.01)*

(52) Cooperative Patent Classification (CPC):
**H03M 7/3084**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **18.03.2025 IN 202541024254**
**15.05.2025 KR 20250063415**

(71) Applicant: **Samsung Electronics Co., Ltd.**
**Suwon-si, Gyeonggi-do 16677 (KR)**

(72) Inventors:
- **Roy, Arnab**
  **560048 Bengaluru, Karnataka (IN)**
- **Juneja, Madhur**
  **560048 Bengaluru, Karnataka (IN)**
- **Chandrasekharan, Kiran Kolar**
  **560048 Bengaluru, Karnataka (IN)**
- **Burada, Nihar VenkataRaj**
  **560048 Bengaluru, Karnataka (IN)**
- **Birmole, Nilay Nitin**
  **560048 Bengaluru, Karnataka (IN)**
- **Nam, Jihoon**
  **16678 Suwon-si, Gyeonggi-do (KR)**
- **Yang, Wooram**
  **16678 Suwon-si, Gyeonggi-do (KR)**

(74) Representative: **Grünecker Patent- und Rechtsanwälte**
**PartG mbB**
**Leopoldstraße 4**
**80802 München (DE)**

(54) **SYSTEM AND METHOD WITH DATA COMPRESSION GENERATION**

(57) A method performed by an electronic device includes receiving an input data stream, loading a set of first elements among a set of elements of the input data stream to a first buffer, generating one or more bit vectors based on a comparison between the set of first elements in the first buffer and a set of second elements in a second buffer among the set of elements of the input data stream, determining a match length corresponding to a bit sequence that satisfies a determined match condition based on the one or more bit vectors, determining a mismatch length corresponding to a bit sequence that satisfies a determined mismatch condition based on the one or more bit vectors, and generating compressed data for the input data stream based on the match length and the mismatch length.

100
101
103
Index 0 1 2 3 4 5 6 7 8 9 10 11 12 13 14 15 16 18 19 20 21 22 23 24 25 26 27 28 29 30
8b data a b c d e f g a b c d e x y z e f g a b c d e m p b c d e f g
Scanned area 110
Scanning-in-progress area 120

**FIG. 1**



Processed by Luminess, 75001 PARIS (FR)

## Description

BACKGROUND

1. Field

The present disclosure relates to the field of data compression technology, and more particularly, to a method of generating compressed data by using Lempel-Ziv (LZ) 4 compression, an electronic device for performing the method, and a non-transitory computer-readable storage medium.

2. Description of Related Art

Contemporary high-performance computing requires enhanced memory capacity, increased bandwidth, and optimized computational efficiency in a focused area. Compression may be used to reduce the usage of memory and memory bandwidth. An efficient compression method requires a balanced compression ratio and compression speed. The compression ratio is generally the ratio of an original data size to a compressed data size.

Various data compression methods include identifying a similar byte sequence by analyzing history (or previous) data. For example, a scheme, such as Huffman coding and run-length encoding (RLE), may efficiently encode recurring bytes to reduce redundancy. Adictionary-based algorithm, such as Lempel-Ziv (LZ) variants, may replace recurring patterns of multiple bytes with references to previously identified data. Specifically, finding a large sequence of bytes (or characters) from the previous data may be required to achieve a higher compression ratio.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is what is claimed in the independent claims. Preferred embodiments are specified in the dependent claims.

In one general aspect, an electronic device includes one or more processors including processing circuitry, and memory including one or more storage media storing instructions, wherein the instructions, when individually or collectively executed by the one or more processors, cause the electronic device to perform a process comprising: receiving an input data stream; loading a set of first elements among a set of elements of the input data stream to a first buffer; generating one or more bit vectors based on a comparison between the set of first elements included in the first buffer and a set of second elements included in a second buffer among the set of elements of the input data stream; determining a match length corresponding to a bit sequence that satisfies a determined match condition based on the one or more bit vectors; determining a mismatch length corresponding to a bit sequence that satisfies a determined mismatch condition based on the one or more bit vectors; and generating compressed data for the input data stream based on the match length and the mismatch length.

The generating of the compressed data for the input data stream includes generating compression information based on the match length and the mismatch length, and generating the compressed data for the input data stream based on the compression information.

The generating of the compression information includes, when the bit sequence that satisfies the determined match condition exists, determining a maximum length from match lengths determined based on the one or more bit vectors as the match length, generating match information including the match length and a position in the second buffer corresponding to the match length, and generating the compression information based at least on the match information.

When a bit sequence of consecutive "1" bits corresponding to a depth of the first buffer exists in the one or more bit vectors, the match information further includes an indicator of the bit sequence of consecutive "1" bits corresponding to the depth of the first buffer.

The generating of the compressed data for the input data stream based on the compression information includes generating the compressed data by storing, in an output buffer, a literal string of the input data stream and a compression block including the match information, wherein the storing is performed according to a size of a reserved space of the output buffer determined based on the match length.

The generating of the compression information includes, when the bit sequence that satisfies the determined match condition does not exist, determining a minimum mismatch length from mismatch lengths determined based on the one or more bit vectors, generating mismatch information including the minimum mismatch length and one or more first elements of the first buffer corresponding to the minimum mismatch length, and generating the compression information based at least on the mismatch information.

The generating of the compressed data based on the compression information includes generating the compressed data by storing, through multi literal transfer (MLT), the one or more first elements of the first buffer corresponding to the minimum mismatch length in an output buffer as a literal string of a compression block.

The determined match condition includes a bit sequence of at least one of the one or more bit vectors representing a number of consecutive "1" bits greater than or equal to a predefined threshold.

The determining of the match length includes, when a bit sequence of consecutive "1" bits corresponding to a depth of the first buffer does not exist in the one or more bit vectors, determining a maximum length from lengths of bit sequences satisfying the determined match condition as the match length.

The determined mismatch condition includes, in at least one of the one or more bit vectors, a bit sequence being a bit sequence before a predefined threshold number of consecutive "1" bits appear for a first time.

The generating of the one or more bit vectors includes generating the one or more bit vectors based on the comparison between the set of first elements and the set of second elements by using a comparator chain including XNOR gates.

The set of second elements of the second buffer includes at least some of elements that were previously processed among the set of elements of the input data stream.

In another general aspect, a method performed by an electronic device includes: receiving an input data stream; loading a set of first elements among a set of elements of the input data stream to a first buffer; generating one or more bit vectors based on a comparison between the set of first elements included in the first buffer and a set of second elements included in a second buffer among the set of elements of the input data stream; determining a match length corresponding to a bit sequence that satisfies a determined match condition based on the one or more bit vectors, determining a mismatch length corresponding to a bit sequence that satisfies a determined mismatch condition based on the one or more bit vectors, and generating compressed data for the input data stream based on the match length and the mismatch length.

In another general aspect, a non-transitory computer-readable storage medium stores one or more programs including instructions, wherein the instructions, when individually or collectively executed by at one or more processors of an electronic device, cause the electronic device to: receive an input data stream; load a set of first elements among a set of elements of the input data stream to a first buffer; generate one or more bit vectors based on a comparison between the set of first elements in the first buffer and a set of second elements in a second buffer among the set of elements of the input data stream; determine a match length corresponding to a bit sequence that satisfies a determined match condition based on the one or more bit vectors; determine a mismatch length corresponding to a bit sequence that satisfies a determined mismatch condition based on the one or more bit vectors; and generate compressed data for the input data stream based on the match length and the mismatch length.

Other features and aspects will be apparent from the following detailed description, the drawings, and the claims.

BRIEF DESCRIPTION OF THE DRAWINGS

FIG. 1 illustrates a history-based compression method according to one or more embodiments.

FIGS. 2A and 2B illustrate a Lempel-Ziv (LZ) 4 compression block according to one or more embodiments.

FIG. 3A illustrates a buffer architecture used for data compression and pattern matching, according to one or more embodiments.

FIG. 3B illustrates a comparator chain according to one or more embodiments.

FIG. 3C illustrates a buffer architecture according to one or more embodiments.

FIG. 3D illustrates an LZ4 compressed data format according to one or more embodiments.

FIG. 4 illustrates a system for generating compressed data, according to one or more embodiments.

FIG. 5 is a flowchart of a method of generating compressed data, according to one or more embodiments.

FIG. 6 illustrates a method of determining a match length corresponding to at least one bit vector, according to one or more embodiments.

FIG. 7A illustrates an LZ compressor that determines a match length corresponding to at least one bit vector,

according to one or more embodiments.

FIG. 7B illustrates a method of determining a mismatch length corresponding to at least one bit vector, according to one or more embodiments.

FIG. 8 illustrates an LZ4 compressor that determines a match length and a mismatch length corresponding to at least one bit vector, according to one or more embodiments.

FIG. 9A illustrates an LZ4 compressed data format according to one or more embodiments.

FIG. 9B illustrates a sequence of operations using LZ4 compressed data for an output buffer, according to one or more embodiments.

FIG. 10 illustrates an electronic device according to one or more embodiments.

Throughout the drawings and the detailed description, unless otherwise described or provided, the same or like reference numerals will be understood to refer to the same or like elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be

interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

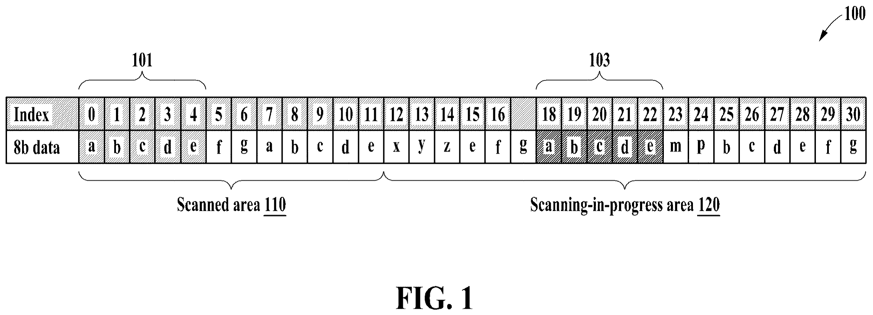

FIG. 1 illustrates a history-based compression method according to one or more embodiments.

Referring to FIG. 1, a string (or a character string) 100 may include 8-bit characters, for example. The string 100 may be being copied, with the history-based compression method, from a source (e.g., a first memory) to a target (e.g., a second memory). The string 100 may include two areas: a scanned area 110 and a scanning-in-progress area 120. The scanned area 110 may extend as scanning progresses.

The scanned area 110 may be an area in which patterns have been searched for and found. The scanned area 110 may also be referred to as "history". For example, a pattern 101 "abcde", may have been found in the scanned area 110 (i.e., the first instance of "abcde" in the string 100). The pattern 101 may be referred to as a matched pattern or a matched string. In the example of FIG. 1, the pattern 101 has been found at position 0 and the length (or size) of the pattern 101 is 5.

Instead of copying the found pattern 101 from the source to the target, the compression method may, based on matching the found pattern 101 with the previously found equivalent, encode match information of the pattern 101 by using a tuple (e.g., {loc=0, size=5}) and may store this encoded data as compressed data (using the corresponding tuple or a reference thereto).

The data prior to the matched pattern for which no matches with previously-found patterns were found may be referred to as unmatched strings. An unmatched string (or a character of the unmatched string) may also be referred to as a "literal". The unmatched string (e.g., "fg" of FIG. 1) may be copied from the uncompressed memory in the source to the compressed data (i.e., in uncompressed form) in the target.

The scanning-in-progress area 120 includes data that has not been scanned yet. After processing the matched string and unmatched string (or after storing corresponding information in the compressed data), the scanning-in-progress area 120 may become a part of the scanned area 110.

Referring to FIG. 1, the pattern 101 "abcde" is not copied in its string form. Instead, corresponding compressed data (e.g., a code/reference/tuple of the string 103) may be stored in place of the string 103 in the target copy by using only the start position (in other words, 0) and the pattern length (in other words, 5) of the pattern 101 in the scanned area (or history) 110.

As the number of patterns matching the input data increases, the number of bits required to encode the input data may decrease, and thus, a compression ratio (or a ratio of the original data size to the compressed data size) may be improved.

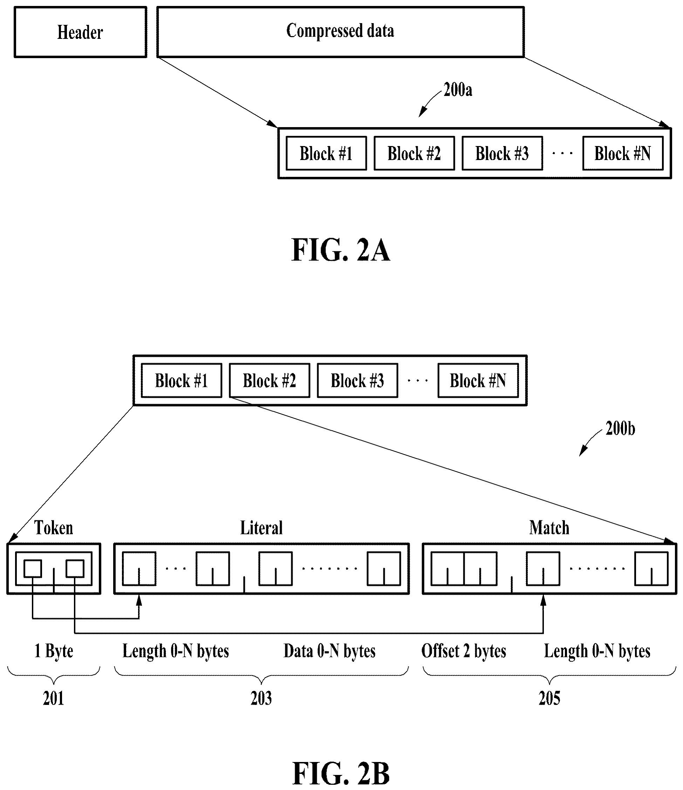

FIGS. 2A and 2B illustrate a Lempel-Ziv (LZ) 4 compression block according to one or more embodiments. Due to its speed in compression and decompression, LZ4 compression may be suitable for scenarios where speed is important.

Referring to FIG. 2A, an LZ4 compression method may generate a chain 200a of LZ4 blocks (or compression blocks). For example, the chain 200a of LZ4 blocks may include block #1 to block #N.

An LZ4 block may be configured to balance encoding bits for both matched and unmatched strings. The LZ4 block may have an unfixed/variable size. An LZ4 block may store information about the matched and unmatched strings therein.

Referring to FIG. 2B, an LZ4 block 200b may include three sections: a token section 201, a literal section 203, and a match section 205. The token section 201 includes a first portion (e.g., half-byte) (e.g., Token[7:4] (a bit-range) or Token.L) with information about the length of the literal section 203 and a second portion (e.g., a half-byte) (e.g., Token[3:0] (a bit-range) or Token.M) with information about the length of the match section 205.

A total literal length lit_length may be calculated based on the first portion (e.g., 4-bit (Token[7:4]) (required)) of the token section 201 and a length part (LITERAL.Length) (optional) of the literal section 203 as follows.

```
  If Token[7:4] < 0xF (which indicates that
 there is no LITERAL.Length byte): lit_length =
 Token[7:4].
  else:
  The LITERAL.Length byte may be valid until a byte other than 0xFF is found, and
 LITERAL.Length[N-1] ≠ 0xFF holds true.
```

After scanning LITERAL.Length bytes, unmatched characters up to the total literal length lit_length may be copied to the LZ4 block 200b (e.g., block #1).

The match length of the match section 205 may vary depending on a reference value of the match length. For example, the reference value of the match length may be 4. When 4 bytes or more (bytes which correspond to the minimum length of 4) are matched, the match section 205 may be formed. The match offset size of a 2-byte (or 16-bit) offset may be used to indicate a match position, and the maximum input string size may be $2^{16}$ = 64 KB.

The total match length match_length may be calculated based on the second 4-bit portion (Token[3:0]) (required) of the token section 201 and the length part (MATCH.Length) (optional) of the match section 205 as follows.

```
  If Token[3:0] < 0xF (which indicates that there is no MATCH.Length byte): match_length
= Token[3:0] + 4 (the reference value of the match length)
  else: (the reference value of
the match length)
```

The MATCH.Length byte may be valid until a byte other than 0xFF is found, and MATCH.Length[N-1] ≠ 0xFF holds true.

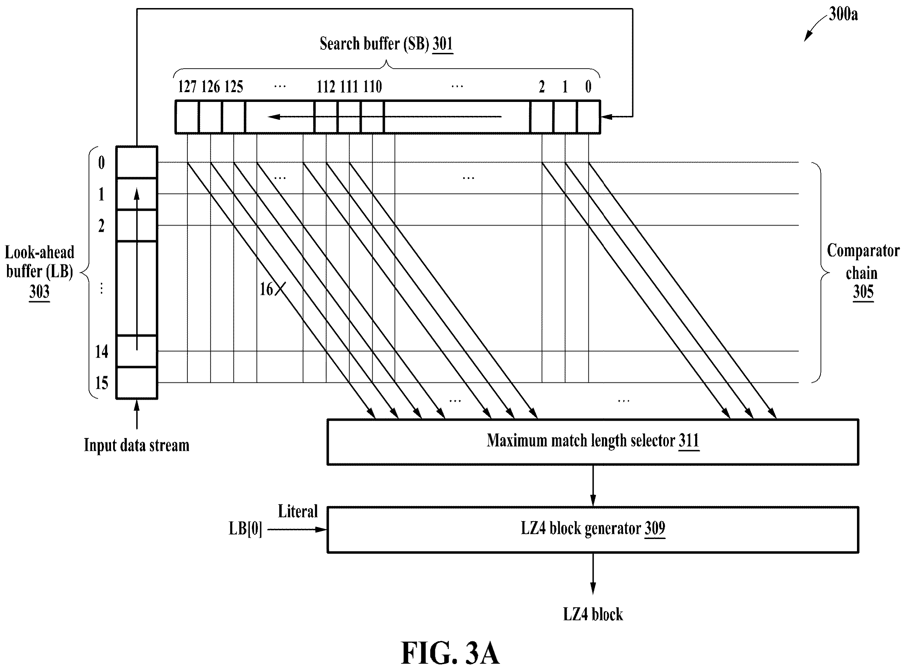

FIG. 3A illustrates a buffer architecture 300a used for data compression and pattern matching, according to one or more embodiments.

The buffer architecture 300a may include a search buffer (SB) 301, a look-ahead buffer (LB) 303, a comparator chain 305, an LZ4 block generator 309, and a maximum match length selector 311.

The SB 301 may enable reference-based compression by storing the history of scanned characters. For example, the SB 301 may have a size of 128 bytes.

The LB 303 may hold (or buffer) incoming characters from an input data stream. The characters in the LB 303 may be compared to the data (or history) stored in the SB 301. For example, the LB 303 may have a size of 16 bytes.

The comparator chain 305 may generate (or output) a bit vector representation related to a match item (matches) by processing a comparison operation between corresponding elements of the SB 301 and the LB 303 (as indicated by the comparator chain 305).

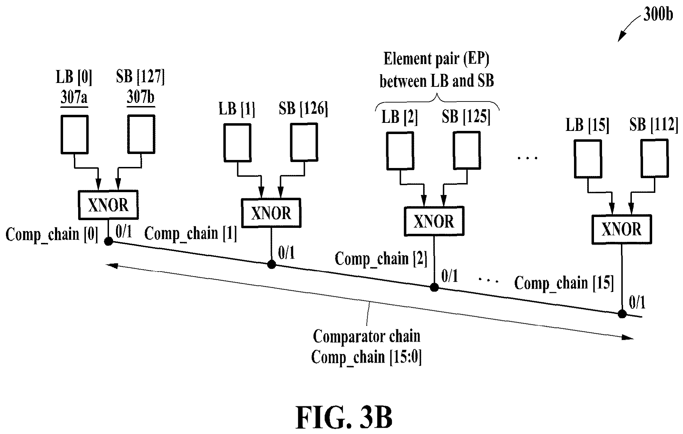

FIG. 3B illustrates a comparator chain according to one or more embodiments.

A comparator chain 300b (e.g., the comparator chain 305 of FIG. 3A) may process a comparison operation between an element of an LB 307a (e.g., the LB 303 of FIG. 3A) and an element of an SB 307b (e.g., the SB 301 of FIG. 3A). The element from the LB 307a and the element from the SB 307b for comparison may be referred to as an element pair (EP).

The elements of each EP may be compared by using a respectively corresponding logic gate (e.g., an XNOR gate).

The XNOR gate corresponding to an EP may generate an output 0 when the elements of the corresponding EP are different from each other. When the elements of the EP are different from each other, it may be referred to as a "mismatch".

The XNOR gate may generate an output 1 when the elements of the corresponding EP are the same. When the elements of the EP are the same, it may be referred to as a "match".

The comparator chain 300b may generate bit vectors consisting of 0 and 1 (0s and 1s) by performing comparison operations on various EPs in parallel by using the XNOR gates. For example, the comparator chain 300b may generate a bit vector Comp_chain[15:0] as shown in FIG. 3B as a comparison result between the elements of the LB 307a and the respectively corresponding elements of SB 307b. The bit vector may be input to a match length encoder to calculate a match length value.

For example, as shown in FIG. 3B, the bit vector Comp_chain[15:0] may be a 16-bit vector generated according to outputs of 16 XNOR gates comparing respectively corresponding EPs. The outputs of the XNOR gates may be captured and may be respectively stored as Comp_chain[0] to Comp_chain[15].

Table 1 indicates examples of 16-bit vectors (or Comp_chain[15:0]) output by the comparator chain 300b. The example 16-bit vectors are in the left column, and corresponding interpretations (meanings) are in the right column. Each bit of a bit vector may correspond to a comparison result of one EP between the LB 307a and the SB 307b.

Table 1

| Bit vector Comp chain[15:0] | Interpretation |
|---|---|
| 1111_1111_1111_1111 | All EPs match |
| 0000_0000_0000_0000 | None of the EPs match |
| 0000_0000_0000_1111 | EP[3:0] is matched |
| 0000_0000_0100_1111 | EP[3:0] and EP[6] are matched |
| 0000_1001_1111_1111 | EP[7:0], EP[8], and EP[11] are matched |

In the examples of Table 1, a binary bit "1" at an arbitrary position indicates a match of the corresponding EP, and a binary bit "0" at an arbitrary position indicates a mismatch of the corresponding EP.

For example, a bit vector value of 1111_1111_1111_1111 indicates that all 16 EPs match, and a bit vector value of 0000_0000_0000_0000 indicates that none of the 16 EPs match.

In a partial match scenario, 0000_0000_0000_1111 indicates that only EP[3:0], which is the bottom four EPs, is matched, 0000_0000_0100_1111 indicates that EP[3:0] and EP[6] are matched, and 0000_1001_1111_1111 indicate that EP[7:0], EP[8], and EP[11] are matched. A "partial match" occurs when a number of element pairs fewer than the depth of the LB 307a are matched.

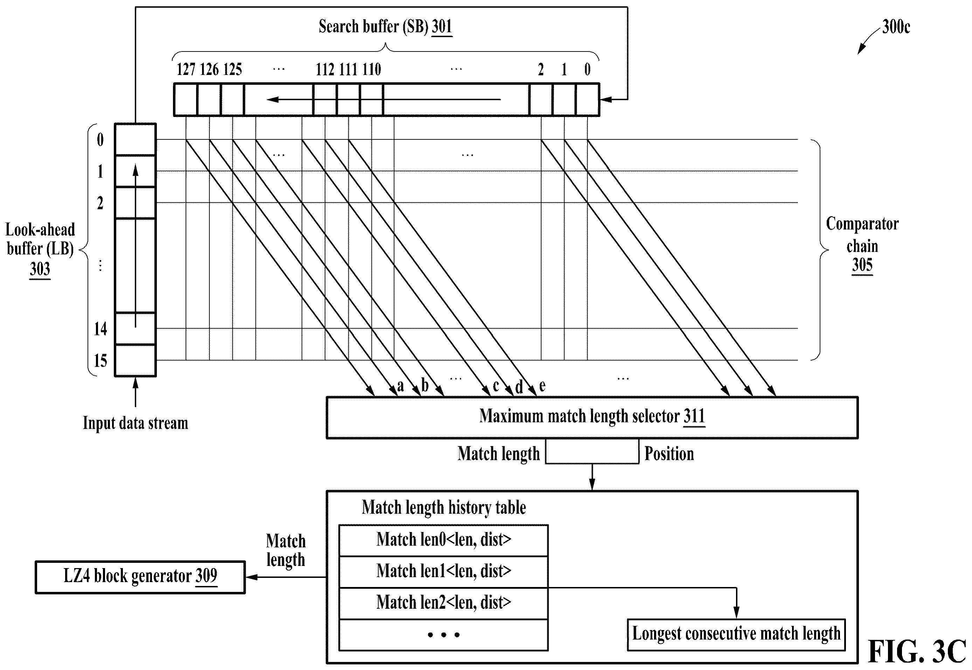

FIG. 3C illustrates a buffer architecture 300c according to one or more embodiments.

The buffer architecture 300c in an embodiment may include the SB 301, the LB 303, the comparator chain 305, the LZ4 block generator 309, and the maximum match length selector 311.

The buffer architecture 300c may achieve a higher compression ratio based on the maximum match length. Repeated comparison operations between match lengths may be employed to find a greater match length.

The match length may provide a clue to find a potentially greater match length. For example, the buffer architecture 300c may find a case in which a bit value (or LB[depth_LB-1] XNOR SB[i]) of the comparator chain 305 is 1 between the last element of the LB 303 and an i-th element of the SB 301. depth_LB indicates the depth (e.g., 16) of the LB 303, depth_SB indicates the depth (e.g., 128) of the SB 301, and i may be between depth_LB and depth_SB.

For example, the match lengths may be denoted as a, b, c, d, and e. a and d may indicate that all 16 elements match. b, c, and e may respectively indicate that 15, 13, and 12 elements match.

A maximum match length selector 311 may identify the match lengths and may store the match lengths in a match length history (e.g., a match length history table). The maximum match length selector 311 may determine the longest match length based on match length history.

To retrieve the longest match length from the compression history, a logic mechanism may need to be implemented to maintain a storage of previously identified match lengths and find the longest match. The time taken to find and compare previous matches may directly affect the overall compression performance.

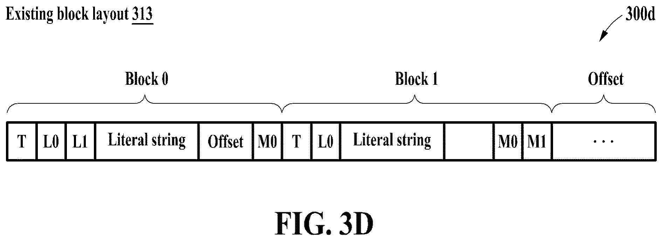

FIG. 3D is a schematic diagram of an LZ4 compressed data format 300d according to one or more embodiments.

The LZ4 compressed data format 300d may include an existing block layout 313. When the existing block layout 313 is strictly followed, it may be uneasy to use a block for an output buffer. The total literal length may be completely determined when all literals are processed, for example.

Since multiple literals may be consecutively generated, an LZ4 compression method that easily predicts the number of bytes to be reserved to store L0, L1, ..., Ln-1 (if necessary) after a token T may be required.

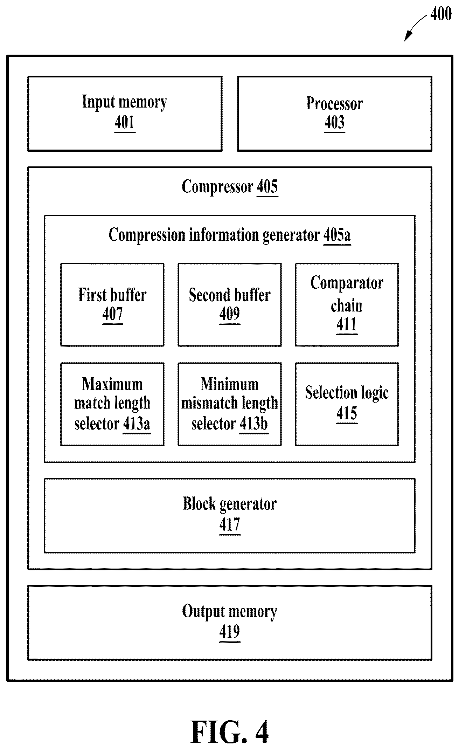

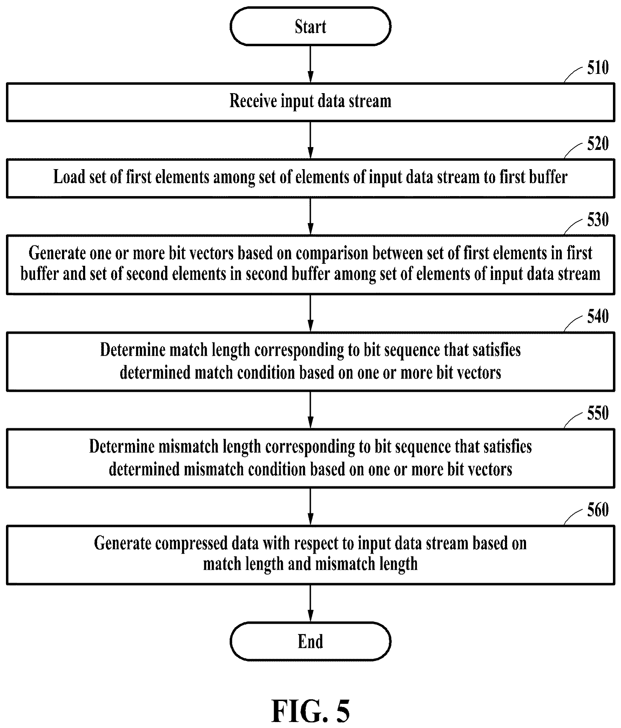

FIG. 4 illustrates a system 400 for generating compressed data, according to one or more embodiments. FIG. 5 illustrates a method of generating compressed data, according to one or more embodiments.

The system 400 for generating compressed data (hereinafter, referred to as the "system") may be used for generating compressed data by using an LZ4 compression method.

The system 400 may include an input memory 401, a processor 403, a compressor 405, a block generator 417, and an output memory 419. However, components of the system 400 are not limited to the illustrated example.

The compressor 405 may include a compression information generator 405a. The compression information generator 405a may include a first buffer 407, a second buffer 409, a comparator chain 411, a maximum match length selector 413a, a minimum mismatch length selector 413b, and a selection logic (or multiplexer) 415.

The input memory 401 (e.g., for receiving streamed data), the compressor 405, and the output memory 419 may be connected with the processor 403.

The system 400 may be an electronic device, such as a mobile device, a laptop, or any device for performing the method of generating compressed data of the present disclosure, or a part of the electronic device.

The input memory 401 and the output memory 419 may be any non-transitory computer-readable medium known in the art including, for example, volatile memory, such as static random access memory (SRAM) and dynamic RAM (DRAM), and/or non-volatile memory, such as read-only memory (ROM), erasable programmable ROM (EPROM), flash memory, a hard disk, an optical disk, and/or magnetic tape.

The input memory 401 and/or the output memory 419 may store instructions of an operating system (OS) for performing one or more tasks of the system 400, such as those performed by a generic OS in a data compression domain (e.g., in a memory controller or a memory manager).

The input memory 401 may store an input data stream to be compressed. The input data stream may include multiple elements. The output memory 419 may store a compressed data stream.

The processor 403 may be a single processing unit or multiple units respectively including computing units. The processor 403 may be implemented as one or more microprocessors including processing circuitry, a microcomputer, a microcontroller, a digital signal processor (DSP), a central processing unit (CPU), a state machine, logic circuitries, and/or any device for controlling a signal based on an operation instruction. The processor 403 may be configured to fetch and execute computer-readable instructions and data stored in the input memory 401 and the output memory 419.

The first buffer 407 may include a set of first elements among the elements of the input data stream. For example, the first buffer 407 may hold (or buffer) incoming characters of the input data stream that are compared with data stored in

the second buffer 409. The first buffer 407 may cause the system 400 to efficiently determine the match length.

The second buffer 409 may include a set of second elements among the elements of the input data stream. For example, the second buffer 409 may include history data. The history data may indicate the input data stream (or a portion of the input data stream) that is already processed.

The second buffer 409 may store previously scanned characters in the input data stream, and may be referenced to find a repeated sequence. The second buffer 409 may be referenced to identify matches between the history (or past) data and new data.

The first buffer 407 and the second buffer 409 may achieve rapid and efficient pattern matching by identifying a repeated sequence by comparing the new input data to the history data and using the repeated sequence for compression.

The selection logic (or multiplexer) 415 may be used to generate compression information by dynamically selecting a data input from different data inputs based on a predefined condition.

When a bit sequence that satisfies a determined match condition is found, the selection logic 415 may prioritize generating the compression information by using the match information (e.g., the match length, the match position (or offset or distance), or a maximum consecutive match). For example, the match information may include a match length of the bit sequence that satisfies the determined match condition and a position in the second buffer 409 corresponding to the match length. For example, when a bit sequence (or a maximum consecutive match) representing consecutive "1" bits corresponding to the length of the first buffer 407 exists among the bit vectors, the match information may include an indicator of the corresponding maximum consecutive match.

When a bit sequence that satisfies the determined match condition is not found, the selection logic 415 may generate compression information by using mismatch information (e.g., a mismatch length or content (or elements) of the first buffer 407 corresponding to the mismatch length). For example, the mismatch information may include a minimum mismatch length. Herein, mismatch_length and LB[i] may respectively indicate the mismatch length and the content (or element) of the first buffer 407.

The block generator 417 may dynamically generate a literal string (or a mismatch string) from the content of the first buffer 407 by using the mismatch information (e.g., mismatch_length) of the compression information.

For example, when the mismatch length is 6, the block generator 417 may generate the literal string in the LZ4 block by selecting LB[0:5] (i.e., the first six elements of the first buffer 407).

The compressor 405 may compress the input data stream received from the input memory 401. The compressor 405 may generate the compressed input data stream based on the match length and the mismatch length. The compressor 405 may implement any of the techniques described herein.

In an embodiment, the compressor 405 may be configured to perform the method of generating compressed data as described with reference to FIG. 5. The compressed data may represent the compressed data stream based on one or more LZ4 blocks.

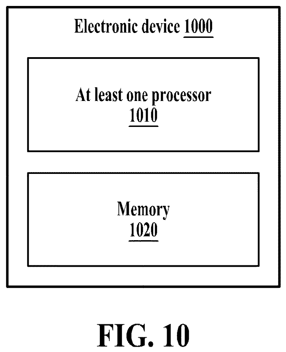

According to an embodiment, referring to FIG. 5, operations 510 to 560 may be performed by an electronic device (e.g., an electronic device 1000 of FIG. 10). The electronic device may include one or more processors including processing circuitry. The electronic device may include at least one memory including one or more storage media storing instructions. The instructions, when executed by the one or more processors individually or collectively, may cause the electronic device to perform at least some of operations related to the method of generating compressed data of the present disclosure.

The electronic device may include at least some of the components of the system 400 described with reference to FIG. 4. For example, the electronic device may include a first buffer (e.g., the first buffer 407 of FIG. 4), a second buffer (e.g., the second buffer 409 of FIG. 4), a comparator chain (e.g., the comparator chain 411 of FIG. 4), a maximum match length selector (e.g., the maximum match length selector 413a of FIG. 4), a minimum mismatch length selector (e.g., the minimum mismatch length selector 413b of FIG. 4), a selection logic (e.g., the selection logic 415 of FIG. 4), and a block generator (e.g., the block generator 417 of FIG. 4).

In operation 510, the electronic device may receive an input data stream of elements.

In operation 520, the electronic device may load a set of first elements (among the elements of the input data stream) to the first buffer.

The first buffer may include the set of first elements among the elements. The electronic device may buffer the set of first elements in the first buffer.

In operation 530, the electronic device may generate one or more bit vectors based on a comparison between the set of first elements included in the first buffer and a set of second elements included in the second buffer (the second elements among the elements of the input data stream).

The first buffer may be an LB. The second buffer may be an SB. An i-th element of the first buffer will sometimes be referred to as LB[i], and an i-th element of the second buffer will sometimes be referred to as SB[i].

The set of second elements of the second buffer may include at least some of elements that were previously processed among the elements of the input data stream.

Each of the one or more bit vectors may be a binary representation of a match result obtained by comparing each

element (or character) of the first buffer with a corresponding/paired element of the second buffer. Each bit of the bit vector may indicate whether an element is matched at a corresponding position.

The electronic device may generate the one or more bit vectors based on the comparison between the set of first elements and the set of second elements by using the comparator chain comprised of XNOR gates.

For example, the electronic device may generate a bit vector based on a comparison between the set of first elements LB[0:15] of the first buffer and the set of second elements SB[127:112] of the second buffer and may generate a bit vector based on a comparison between the set of first elements LB[0:15] of the first buffer and another set of second elements SB[111:96] of the second buffer. The depths (or sizes) of the first buffer and the second buffer and the number of bit vectors are not limited to the described example.

In operation 540, the electronic device may determine a match length corresponding to a bit sequence that satisfies a determined match condition based on the one or more bit vectors.

The determined match condition may include a bit sequence (or bits) of at least one of the one or more bit vectors representing a number of consecutive "1" bits greater than or equal to a predefined threshold.

For example, when the predefined threshold is 3, the electronic device may determine that a bit sequence, such as "111" or "11111", satisfies the determined match condition. In addition, when all bits of an arbitrary bit vector are "1", the electronic device may determine that the bit vector satisfies the determined match condition.

Specifically, the electronic device may identify a consecutive "1" bit sequence satisfying the determined condition from the one or more generated bit vectors. The electronic device may determine the match length of the consecutive "1" bit sequence satisfying the determined match condition.

In operation 550, based on the one or more bit vectors, the electronic device may determine a mismatch length corresponding to a bit sequence that satisfies a determined mismatch condition.

The determined mismatch condition may include a bit sequence (or bits) being a bit sequence before a predefined threshold number of consecutive "1" bits appear for the first time in at least one of the one or more bit vectors.

For example, when the predefined threshold is 3, the electronic device may determine that a bit sequence of "0" and/or "1" until "111" appears for the first time satisfies the determined mismatch condition.

Specifically, the electronic device may identify the bit sequence of "0" and/or "1" satisfying the determined mismatch condition from the one or more generated bit vectors. The bit sequence satisfying the determined mismatch condition may also be referred to as a mismatch (or mismatch sequence). The electronic device may determine a mismatch length of the mismatch.

Operation 550 may involve scanning bit vectors until a bit sequence satisfying the determined match condition is identified. The electronic device may scan one or more bit vectors until the bit sequence satisfying the determined match condition is identified. The electronic device may scan a bit sequence of "0" and/or "1" from one or more bit vectors until the bit sequence satisfying the determined match condition is identified, and may determine the length thereof as the mismatch length.

In some embodiments, the electronic device may determine a minimum value of the lengths of the bit sequences that are scanned until the bit sequence satisfying the determined match condition is identified from one or more bit vectors, as the mismatch length.

According to an embodiment, in operation 540, the electronic device may determine whether there is a bit sequence of consecutive "1" bits corresponding to the depth depth_LB of the first buffer in the one or more bit vectors. The bit sequence of consecutive "1" bits corresponding to the depth of the first buffer may have the greatest match length from the corresponding bit vector. The consecutive "1" bit sequence corresponding to the depth of the first buffer may also be referred to as a maximum consecutive match. For example, the compressor 405 of FIG. 4 may mainly aim to identify consecutive matches of the greatest match length.

When a bit sequence representing consecutive "1" bits corresponding to the depth of the first buffer does not exist in the one or more bit vectors (or the maximum consecutive match does not exist), the electronic device may determine the maximum length of the lengths of the bit sequences satisfying the determined match condition as the match length.

Specifically, when only a partial match exists in the one or more bit vectors, the electronic device may determine the match length as the maximum length of the lengths of bit sequences corresponding to the partial match. The "partial match" may indicate that a number of elements fewer than the depth of the first buffer are matched among the first elements of the first buffer and the corresponding second elements of the second buffer.

When the bit sequence satisfying the determined match condition does not exist in the one or more bit vectors (or the match length is not determined), the electronic device may consider the mismatch length.

In operation 560, the electronic device may generate compressed data with respect to the input data stream based on the match length and the mismatch length.

The operation of generating the compressed data with respect to the input data stream based on the match length and the mismatch length may include (i) an operation of generating compression information based on the match length, the mismatch length, and the input data stream and (ii) an operation of generating the compressed data based on the compression information.

In some embodiments, the operation of generating the compression information may include (i) an operation of determining the maximum length of match lengths determined based on the one or more bit vectors when a bit sequence satisfying the determined match condition exists, (ii) an operation of generating the match information including match length and the position in the second buffer corresponding to the match length, and (iii) an operation of generating the compression information based on the match information.

When a bit sequence representing consecutive "1" bits corresponding to the depth of the first buffer exists in the one or more bit vectors, the match information may further include an indicator of the bit sequence representing consecutive "1" bits corresponding to the depth of the first buffer.

When the bit sequence satisfying the determined match condition does not exist, the operation of generating the compression information may include (i) an operation of determining the minimum mismatch length of mismatch lengths determined based on the one or more bit vectors, (ii) an operation of generating the mismatch information including the minimum mismatch length and one or more first elements of the first buffer corresponding to the minimum mismatch length and, (iii) an operation of generating the compression information based on the mismatch information.

In some embodiments, the operation of generating the compressed data based on the compression information may include an operation of generating the compressed data by storing a compression block including the match information and including a literal string of the input data stream in an output buffer (e.g., the output memory 419 of FIG. 4) that is determined based on the match length, according to the size of a reserved space of the output buffer.

In some embodiments, the operation of generating the compressed data based on the compression information may include an operation of generating the compressed data by storing one or more first elements of the first buffer corresponding to the minimum mismatch length in the output buffer as the literal string of the compression block through multi literal transfer (MLT).

Specifically, generation logic for generating the compression information may be as follows.

Match length (match_length) = Maximum value (all match lengths of bit vectors)

If (match_length == 0): // If a bit sequence that satisfies the determined match condition does not exist (or the match length is not determined)

Mismatch length (mismatch_length) = Minimum value (all mismatch lengths of bit vectors)

For example, the compression information may include the following items.

1. Match flag (Match_flag) = if (match_length > predetermined_match_threshold) then 1 otherwise 0 // If a bit sequence that satisfies the determined match condition exists, the match flag is 0, otherwise, the match flag is 0.

2. Consecutive_match = if match_length == depth_LB found // **If** a match length corresponding to the depth of the first buffer exists, the maximum consecutive match exists.

3. If match flag is 1 then Match length and position where the maximum match length is found, otherwise the mismatch length // The match length and position when the match flag is 1. Otherwise, the mismatch length.

4. Contents of the first buffer // Contents (or elements) of the first buffer

The generation logic of the compression information may be described by various scenarios. For example, in the following example, the first buffer may capture one string as an example, and each range of the second buffer may capture strings at different byte positions. For example, range 2 (R2) of the second buffer may include a string from a byte position 67 to a byte position 42.

<Example>

```
Depth of the first buffer (LB) (depth_LB) = 16
Depth of the second buffer (SB) (depth_SB) = 128
Predetermined match threshold = 3
First buffer : ABCDWXYZ1234EFGH
Range 1 (R1): Second Buffer [100:85]: ABWXYZ1234ABCDGH
```

```
Range 2 (R2): Second Buffer [67:42]: ABCDWXYZEFGH1234
Range 3 (R3): Second Buffer [31:16]: ABCDWXYZ1234EFGH
<Comparison between first buffer and R1 of second buffer>
→ Bit vector (Bit_vector_1) = 1100000000000011
→ Match length (match_length_1) = 0, mismatch length (mismatch_length_1) = 16
<Comparison between first buffer and R2 of second buffer>
→ Bit vector (Bit_vector_2) = 1111111100000000
→ Match length (match_length_2) = 8, mismatch length (mismatch_length_2) = 0
<Comparison between first buffer and R3 of second buffer>
→ Bit vector (Bit_vector_3) = 1111111111111111
→ Match length (match_length_3) = 16, mismatch length (mismatch_length_3) = 0
→ Maximum consecutive match
<Scenario 1: When R1, R2, and R3 all exist>
Compression information:
Match_flag = 1 // A bit sequence of which the match length exceeds the predetermined
threshold exists (or corresponds to the match)
Consecutive_match = 1 // The maximum consecutive match exists
match_length = 16, match_pos = 31
<Scenario 2: When only R1 and R2 exist>
Match_flag = 1 // A bit sequence of which the match length exceeds the predetermined
threshold exists (or corresponds to the match)
Consecutive_match = 0 // The maximum consecutive match does not exist
match_length = 8, match_pos = 67
<Scenario 3: When only R1 exists>
Match_flag = 0 // A bit sequence of which the match length exceeds the predetermined
threshold does not exist (or corresponds to the mismatch)
Consecutive_match = 0 // The maximum consecutive match does not exist
match_length = 0, mismatch_length = 16
```

The electronic device may encode the match information based on the match length. Specifically, the match information may be encoded to include the position in the second buffer corresponding to the match length.

For example, when the maximum consecutive match exists, the match information may be encoded to include the maximum match length, the position in the second buffer corresponding to the maximum match length, and an indicator of the maximum consecutive match. Specifically, the match information may include an indicator of a bit sequence representing consecutive "1" bits corresponding to the depth of the first buffer.

The electronic device may encode the mismatch information based on the mismatch length. Specifically, the mismatch information may be encoded to include the mismatch length and one or more first elements of the first buffer corresponding to the mismatch length.

For example, the mismatch information may include the minimum mismatch length and one or more first elements (or the content of the first buffer) of the first buffer corresponding to the minimum mismatch length.

Based on the mismatch information, the electronic device may generate the compressed data by processing literals (or literal strings) of the first buffer.

The processed literals may each be a byte sequence that is not compressed in the input data stream and is stored in the compressed data without modification. As described above, the literal may be the data (or the first element) of the first buffer that is not matched with the data (or the second element) of the second buffer.

The electronic device may generate the compressed data by storing one or more first elements of the first buffer corresponding to the minimum mismatch length in the output buffer through **MLT.**

Based on the match length, the electronic device may dynamically adjust the size of the reserved space of the output buffer for storing the compressed data. The electronic device may allocate (or buffer) an area of the output buffer (or the memory) in advance to store the compressed data. The reserved space may ensure efficient data writing and data storing in the output buffer during the compression process. For example, the electronic device may process the literal string of the input data stream based on the mismatch length. The electronic device may generate the compressed data by storing the literal string of the input data stream and the compression block including the match information according to the size of the reserved space of the output buffer determined based on the match length.

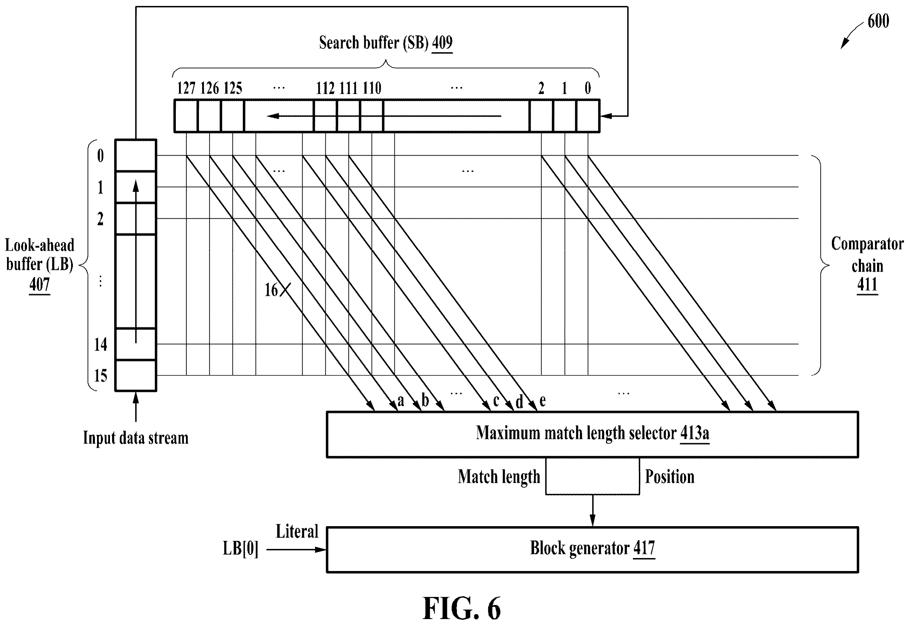

FIG. 6 is a diagram illustrating a method of determining a match length corresponding to at least one bit vector, according to one or more embodiments.

An electronic device 600 (e.g., the electronic device 1000 of FIG. 10) may include the first buffer 407, the second buffer 409, the comparator chain 411, the maximum match length selector 413a, and the block generator 417.

As described with reference to FIG. 5, the electronic device 600 may determine whether a bit sequence of consecutive "1" bits corresponding to the depth of the first buffer 407 exists in bit vectors generated by the comparator chain 411. This may be construed as an operation of determining whether a maximum consecutive match exists in the bit vectors.

When all bits of the bit vector generated by the comparator chain 411 are 1 (in other words, when all corresponding elements match), this case may correspond to the maximum consecutive match.

Referring to FIG. 6, match lengths of the bit vectors may be denoted as a, b, c, d, and e. For example, a and d may correspond to the maximum consecutive match in which all 16 elements match. b, c, and e may respectively indicate that 15, 13, and 12 elements match.

The maximum match length selector 413a may determine the greatest maximum match length among the match lengths of the bit vectors generated by the comparator chain 411. When the match length of an arbitrary bit vector corresponds to the depth of the first buffer 407 (or when all bits of the bit vector are 1), the maximum match length selector 413a may determine the match to be the maximum consecutive match.

The maximum match length selector 413a may track the position of the maximum consecutive match (e.g., a and d) found in a previous iteration. For example, the position of the maximum consecutive match in a current iteration may be valid only when the maximum consecutive match is found at the same position as the maximum consecutive match (e.g., a and d) found in the previous iteration.

Each "iteration" refers to the fact that a comparison operation between elements of the first buffer 407 and elements of the second buffer 409 may be performed when a new element (or byte) of the input data stream is input to the first buffer 407. For example, the current iteration may indicate that whether the maximum consecutive match is maintained at the position of the maximum consecutive match determined in the previous iteration is determined when a new element is input to LB[15] of the first buffer 407.

The maximum match length selector 413a may perform such iterations until the match lengths of all bit vectors corresponding to the position of the maximum consecutive match determined in the previous iteration become smaller than the maximum match length (or the depth of the first buffer 407).

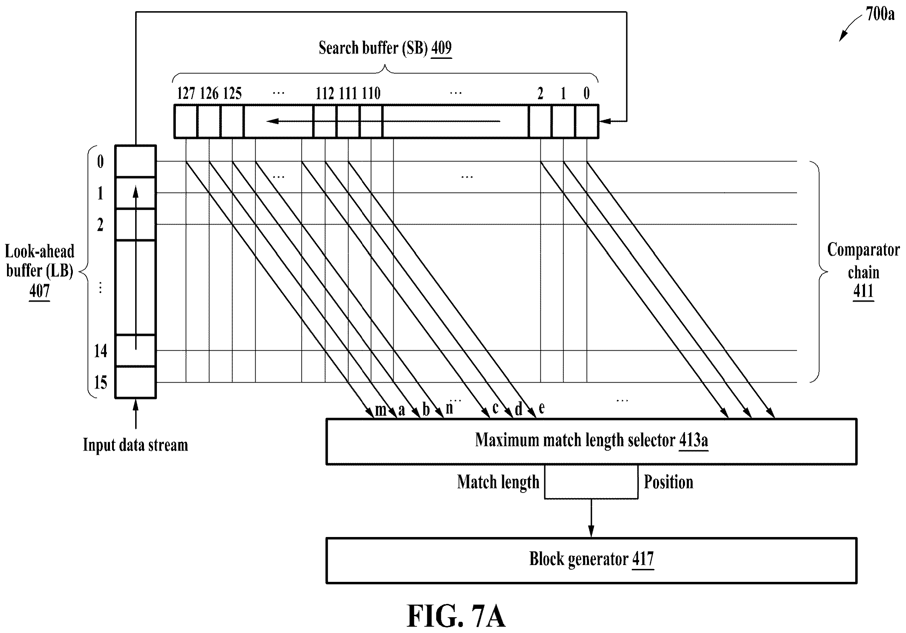

FIG. 7A illustrates an LZ compressor that determines a match length corresponding to at least one bit vector, according to one or more embodiments.

An electronic device 700a (e.g., the electronic device 1000 of FIG. 10) may include the first buffer 407, the second buffer 409, the comparator chain 411, the maximum match length selector 413a, and the block generator 417.

As described with reference to FIG. 6, the electronic device 700a may iteratively perform a comparison operation between elements of the first buffer 407 and elements of the second buffer 409 until a new element (or byte) of the input data stream is input to the first buffer 407.

For example, as described with reference to FIG. 6, in a previous iteration, a and d may correspond to the maximum consecutive match in which all 16 elements match. **In** the previous iteration, a and d may be valid as the maximum consecutive match.

Referring to FIG. 7A, in the current iteration, the maximum consecutive match may be determined at another position in addition to the positions corresponding to a and d. For example, m and n correspond to the maximum consecutive match. However, the maximum match length selector 413a may track only the positions of the maximum consecutive match (a and d) determined in the previous iteration.

For example, when a and d are invalidated in a next iteration after the current iteration (in other words, when a and d do not correspond to the maximum consecutive match), the maximum match length selector 413a may select a maximum match length from the match lengths of a and d. After the next iteration, a new search for the maximum consecutive match may start.

The maximum match length selector 413a may determine the maximum number of bytes of a consecutive bit sequence that coincides with a previously identified bit sequence (or the bit sequence included in the second buffer 409), and this may be used to optimize the compression efficiency.

For data compression and memory management, feedback from the first buffer 407 to the second buffer 409 may indicate a mechanism in which previously processed data stored in the first buffer 407 is utilized or referenced in the configuration of the second buffer 409.

The maximum match length selector 413a may determine the maximum match length based on the maximum consecutive match. The maximum match length may correspond to at least one of the one or more bit vectors generated based on the identified maximum consecutive match.

Pseudocode for determining (or selecting) the match length of the maximum match length selector 413a and the position in the second buffer 409 may be as follows. In the following example pseudocode, "Comp_chain" denotes a bit vector, "comp_chain_len[]" denotes an array of match lengths of each of offsets (or positions), "cont_match" denotes a maximum consecutive (or continuous) match, and "can_cont_match[]" denotes an array of validity of maximum consecutive matches of each of offsets (or positions):

```
Func_sel_cont_match (in second_buff_size, in first_buff_size, in comp_chain_len, in can_cont_match, out length, out location)
{
exist_cont_match = 0;
can_cont_match [second_buff_size-1:0]=1;
length = 0; position = 0;
While(!exist_cont_match){
exist_cont_match = 0; cont_match_len = 0; // Initialize
For(i=0; i<second_buff_size; i++){
If(comp_chain_len[i] == first_buff_size &&
can_cont_match[i] == 1){
exist_cont_match= 1; // The maximum consecutive match exists/is valid
}
Else {
can_cont_match[i] = 0;
If(cont_match_len < comp_chain_len[i]){
cont_match_len = comp_chain_len[i];
location = i; // When the maximum consecutive match does not exist, the maximum length of lengths of bit sequences corresponding to the partial match is determined as the match length.
}
}
}
If (exist_cont_match ==1) {
length = first_buff_size ; // When the maximum consecutive match exists in the iteration, go to the next iteration and track the validity of the maximum consecutive match
}
Else {length = cont_match_len; // When the maximum consecutive match is no longer valid, add the remaining match length
}
}
```

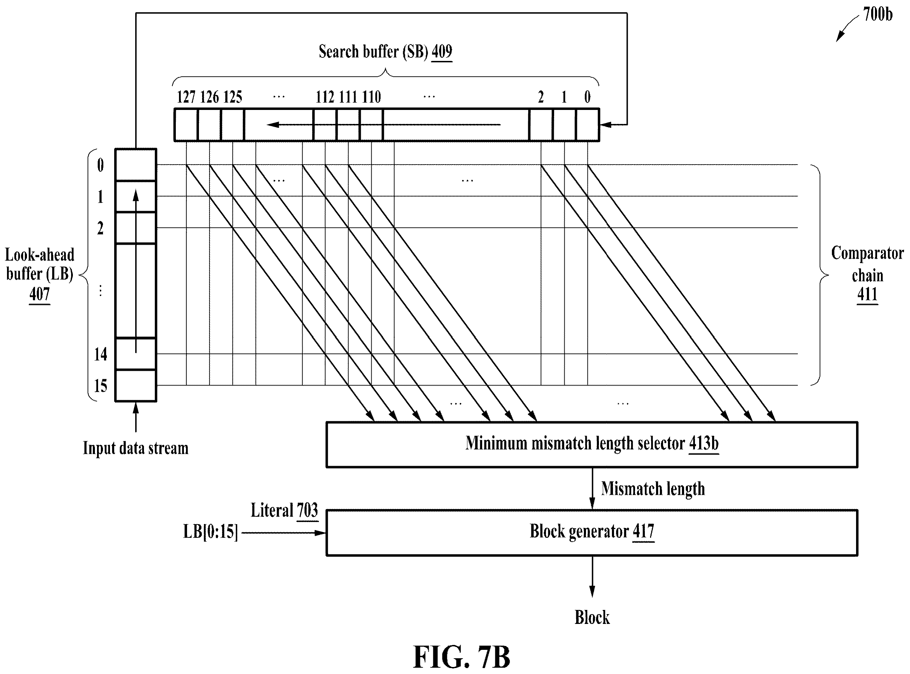

FIG. 7B illustrates a method of determining a mismatch length corresponding to at least one bit vector, according to one or more embodiments.

In some embodiments, an electronic device 700b (e.g., the electronic device 1000 of FIG. 10) may include the first buffer 407, the second buffer 409, the comparator chain 411, the minimum mismatch length selector 413b, and the block generator 417.

As described with reference to FIG. 5, a bit vector generated by the comparator chain 411 may include a bit sequence of "0" and/or "1" before a predefined threshold number of consecutive "1" bits appear for the first time. The length of the bit sequence of "0" and/or "1" that is scanned until a bit sequence satisfying a determined match condition is identified may be determined as the mismatch length.

The minimum mismatch length selector 413b may determine the bit sequence of "0" and/or "1" that is scanned until the bit sequence satisfying the determined match condition is identified as a "mismatch (or mismatch sequence)". The minimum mismatch length selector 413b may determine the mismatch length based on the length of the mismatch sequence.

In the case of a mismatch, in an embodiment, a 1-byte literal 703 may be transmitted to the block generator 417.

In an embodiment, literals may be transmitted to the block generator 417 through MLT.

The comparator chain 411 may calculate the match length and/or the mismatch length. The minimum mismatch length selector 413b may identify the shortest sequence of bytes that do not match until a valid match is resumed in the data compression and pattern matching scheme.

The minimum mismatch length selector 413b may optimize encoding efficiency by detecting the smallest mismatch in repeated data. For example, when a mismatch occurs (or bytes do not match), the minimum mismatch length selector 413b may determine the shortest sequence of bytes that do not match before finding a new valid match.

Encoding by the comparator chain 411 may vary depending on the mismatch length.

Pseudocode for determining the mismatch length of the minimum mismatch length selector 413b may be as follows. For example, "comp_chain[]" denotes an array of bit vectors:

```
Func_calc_mismatch_len(in second_buff_size, in comp_chain, out mismatch_len)
{
mismatch_len = 0
num_bit[0: second_buff_size-1]=1; // Initialize
For(i=0; i< second_buff_size; i++){
For each comp_chain[i]{
    a) Calculate the number of bits until a pattern of a predefined
       threshold number of consecutive "1" bits appear for the first time.
       For example, when the predefined threshold is 3, calculate the
       number of bits until a pattern of "111" appears.
    b) Store the number of bits as num_bit[i].
    c) In the calculation of a), a minimum value of num_bit[i] needs to be
       provided as 1 (since at least a single byte literal needs to be
       transmitted)
}
    }
mismatch_len = minimum(num_bit) // Determine a minimum value in the num_bit array
to be the mismatch length (or minimum mismatch length).
}
```

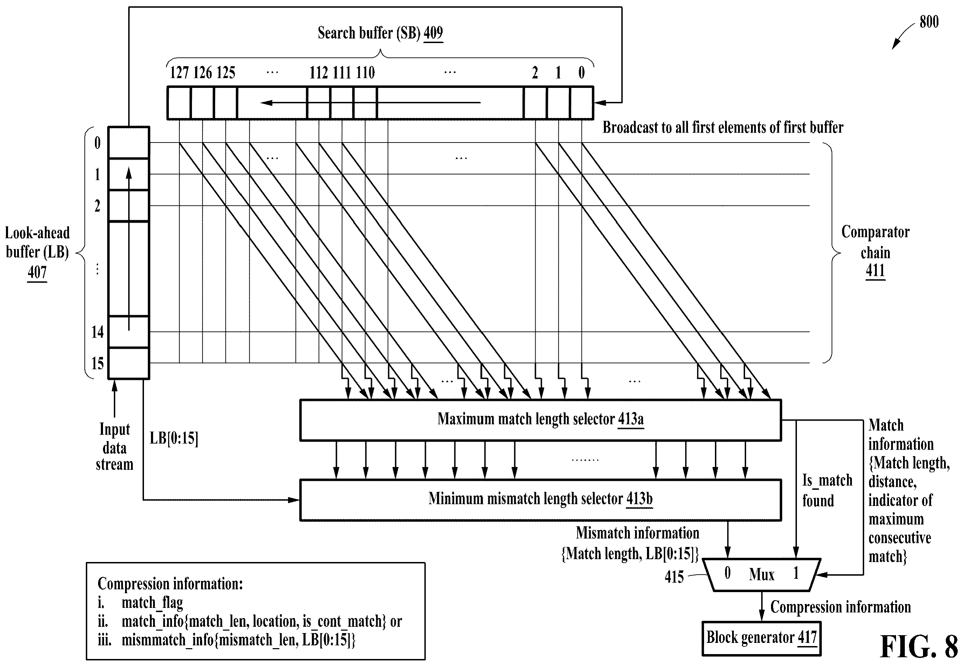

FIG. 8 illustrates an LZ4 compressor that determines a match length and a mismatch length corresponding to at least one bit vector, according to one or more embodiments.

In some embodiments, an electronic device 800 (e.g., the electronic device 1000 of FIG. 10) may include the first buffer 407, the second buffer 409, the comparator chain 411, the maximum match length selector 413a, the minimum mismatch length selector 413b, the selection logic (or multiplexer) 415, and the block generator 417.

The electronic device 800 may perform operations on the match and mismatch in parallel.

The electronic device 800 may generate compression information. The compression information may include (i) a match flag (match_flag), (ii) match information (match_info), or (iii) mismatch information (mismatch_info). When a bit sequence satisfying a determined match condition exists in bit vectors generated as a result of a comparison operation between elements of the first buffer 407 and elements of the second buffer 409, the match flag may be 1, and otherwise, the match flag may be 0.

With respect to the match case, the compression information may include a match length (match_len), a location(or, position) of the second buffer 409 corresponding to the match length, and an indicator of a maximum consecutive match.

With respect to the mismatch case, the compression information may include a mismatch length (mismatch_len) and content (or first elements) (e.g., LB[0:15]) of the first buffer 407 corresponding to the mismatch length.

In the case of mismatch, a compression cycle may be shortened through **MLT** based on the compression information.

The maximum match length selector 413a may compare a byte sequence of a set of first elements currently input to the first buffer 407 with a set of second elements of the second buffer 409. Specifically, the maximum match length selector 413a may find the greatest match length between an input byte sequence and a previous byte sequence.

The maximum match length selector 413a may transmit a result to the minimum mismatch length selector 413b for additional processing.

The minimum mismatch length selector 413b may identify a minimum sequence of bytes that do not match until a valid match satisfying the determined match condition starts or resumes. Since the minimum mismatch length selector 413b enables processing multiple literals instead of a single literal in a single iteration, the minimum mismatch length selector 413b may help reduce the time for performing the compression cycle.

The selection logic 415 may switch between a mismatch mode 0 and a match mode 1.

When a match is found (Is_match found), in the match mode 1, the maximum match length selector 413a may generate match information including the match length and the position (or offset) as a tuple (or a pair). The match information may further include information (e.g., an indicator of the maximum consecutive match (is_cont_match)) whether the match length is a part of ongoing maximum consecutive match tracking.

When a mismatch is found, in the mismatch mode 0, the minimum mismatch length selector 413b may generate mismatch information including the mismatch length and a raw byte (or literal) (e.g., LB[0:15]) of the first buffer 407 corresponding to the mismatch length.

After comparing the set of first elements of the first buffer 407 with the set of second elements of the second buffer 409, the selection logic 415 may generate the compression information in which the match information is combined with

the mismatch information. The compression information may be transmitted to the block generator 417.

When a mismatch occurs, the block generator 417 may, based on the compression information, additionally copy a raw byte (or literal) corresponding to the mismatch length and may store the raw byte into a block (or a compression block). The block may be an LZ4 block.

The block generator 417 may generate one or more blocks based on the compression information. The block generator 417 may store the generated blocks in an output buffer (e.g., the output memory 419 of FIG. 4). The output buffer may store compressed data including one or more blocks.

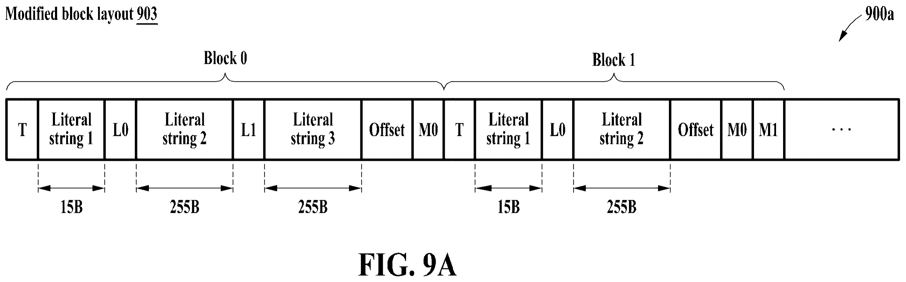

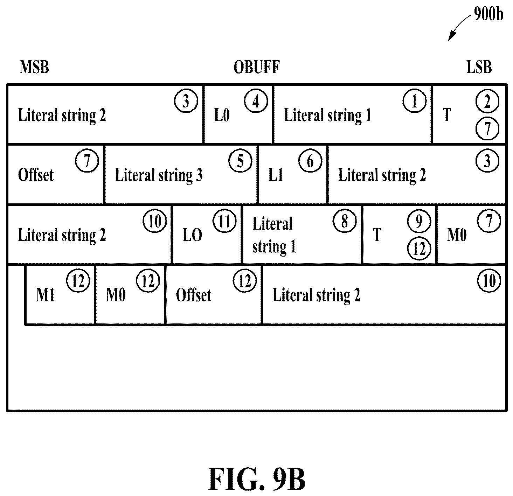

FIG. 9A illustrates an LZ4 compressed data format, according to one or more embodiments. FIG. 9B illustrates a sequence of operations using LZ4 compressed data for an output buffer, according to one or more embodiments.

Referring to FIG. 9A, an LZ4 compressed data format 900a may include a modified block layout 903 (here, "modified" is relative to a standard LZ4 block layout). The modified block layout 903 may enable efficient storage of LZ4 block data in the output buffer.

FIG. 9A illustrates two LZ4 blocks (e.g., block 0 and block 1) as examples. In an output buffer OBUFF shown in FIG. 9B, the sequence of operations is denoted by the circled numbers.

A major advantage (although not necessarily required) of applying the modified block layout 903 as shown in FIG. 9A may be that a literal section (e.g., the literal section 203 of FIG. 2) and a match section (e.g., the match section 205 of FIG. 2) of the LZ4 block may be recorded in the output buffer before a token section (e.g., the token section 201 of FIG. 2) of the LZ4 block is completed. Accordingly, the token section may be recorded after recording the literal section and the match section.

1. An initial byte position (0) may be reserved for later updating of the token section. A literal string from 1 to 15 characters may be recorded after the reserved byte.

2. The token section may be updated at the reserved byte position by modifying T.L (partial length information of the literal).

3. Immediately after the literal string 1, byte LO may be reserved for the partial length information of a literal string 2. For example, the 255-byte literal string 2 may be recorded after the byte position of L0.

4. A value of L0 may be recorded at the byte position of L0.

5. After the end byte position of the literal string 2, another byte L1 may be reserved for the partial length information of a literal string 3. The literal string 3 that is less than 255 bytes may be recorded after the byte position of L1.

6. The byte position of L1 may be updated to the byte length of the literal string 2.

7. Since the match length is calculated after literal processing (in other words, storing a raw byte in the output buffer), the match information (e.g., a match offset (or position) and a match length pair) of the compression information may be recorded together. In this example, the match length is greater than 15 + [predefined threshold], an additional byte M0 may be written for additional match length information. As T.M is updated, the token section may capture another partial match length information. At the end of this sequence 7, block 0 may be completed in the output buffer including the initially reserved area.

8. Now, similarly, a byte position may be reserved for the token section of block 1. After reserving the byte position, a 15-byte literal string 1 may be stored.

9. T.L may be updated at the reserved byte position.

10. A byte position L0 may be reserved for a partial literal length (or mismatch length) representing the length of a literal string 2. The literal string 2 that is less than 255 bytes may be recorded in the output buffer after the reserved byte position.

11. The byte position of L0 may be updated to the byte length of the literal string 2.

12. All match information (the offset, M0, and M1) about block 1 may be updated together with the partial match length information (T.M) about the token section.

FIG. 10 is a block diagram of an electronic device, according to one or more embodiments.

An electronic device 1000 may include one or more processors (hereinafter, also referred to as a processor) 1010 including processing circuitry and a memory 1020 including one or more storage media storing instructions executable by the processor. When the instructions are individually or collectively executed by the processor 1010, the instructions may cause the electronic device 1000 to perform at least a portion of the operations described herein with reference to FIGS. 1 to 13.

The electronic device 1000 may include a communication unit (not shown) connected to the processor 1010 and the memory 1020 to transmit and receive data. The communication unit may be connected to other external devices to transmit and receive data. Hereinafter, the expression transmit and receive "A" may refer to transmit and receive "information or data indicating A".

The communication unit may be implemented by circuitry in the electronic device 1000. For example, the communication unit may be an internal bus or an external bus. In another example, the communication unit may be an element to connect the electronic device 1000 to an external device. The communication unit may be a network interface, for example. The communication unit may receive data from an external device and may transmit the data to the processor 1010 and the memory 1020.

The processor 1010 may process data received by the communication unit and/or data stored in the memory 1020. The "processor" may be a data-processing device implemented by hardware including a circuit having a physical structure to perform desired operations. For example, the desired operations may include code or instructions in a program. For example, the data-processing device implemented by hardware may include a microprocessor, a CPU, a graphics processing unit (GPU), a processor core, a multi-core processor, a multiprocessor, an application-specific integrated circuit (ASIC), and a field-programmable gate array (FPGA).

The processor 1010 may control other components (e.g., a hardware or software component) of the electronic device 1000 and may perform various data processing or computations. As at least a portion of data processing or computation, the processor 1010 may store an instruction or data received from another component (e.g., the communication unit) in at least a portion of the memory 1020, may process the instruction or data stored in the memory 1020, and may store resulting data in the memory 1020. The operations performed by the processor 1010 may be substantially the same as the operations of the electronic device 1000.

The memory 1020 may store information necessary for the processor 1010 to perform a processing operation. The memory 1020 (one or more storage media included in the memory 1020) may store code/instructions executed by the processor 1010 and may store associated information while executing the software or program in the electronic device 1000. For example, the memory 1020 may include one or more memories that are volatile and/or non-volatile in the art, such as random access memory (RAM), dynamic RAM (DRAM), static RAM (SRAM), non-volatile RAM (NVRAM), persistent memory (PMEM), magneto-resistive random memory (MRAM), high bandwidth memory (HBM), and 3DXPoint.

The electronic device 1000 may be connected to an external memory via the communication unit. For example, the external memory may include at least one volatile memory, non-volatile memory, RAM, flash memory, a hard disk drive, and an optical disk drive. The external memory may store a set of instructions (e.g., software) to operate the electronic device 1000. The set of instructions to operate the electronic device 1000 may be executed by the processor 1010.

For example, the processor 1010 may receive an input data stream. The processor 1010 may load a set of first elements among a plurality of elements of the input data stream to a first buffer. The processor 1010 may generate one or more bit vectors based on a comparison between the set of first elements included in the first buffer and a set of second elements included in a second buffer among the plurality of elements of the input data stream. The processor 1010 may determine a match length corresponding to a bit sequence that satisfies a determined match condition based on the one or more bit vectors. The processor 1010 may determine a mismatch length corresponding to a bit sequence that satisfies a determined mismatch condition based on the one or more bit vectors. The processor 1010 may generate compressed data with respect to the input data stream based on the match length and the mismatch length.

The computing apparatuses, the electronic devices, the processors, the memories, the storage devices, and other apparatuses, devices, units, modules, and components described herein, including descriptions with respect to respect to FIGS. 1-10, are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit (ALU), a digital signal processor (DSP), a microcomputer, a programmable logic controller, a field-programmable gate array (FPGA), a programmable logic array (PLU), a microprocessor, or any other device or combination of devices that is configured to respond to and execute instructions (e.g., code or coding) in a defined manner to achieve a desired result. **In** one example, a processor or computer includes, or is connected to, one or more memories storing the instructions or software that are executed by the processor or computer.

Hardware components implemented by a processor or computer may execute the instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both, and thus while some references may be made to a singular processor or computer, such references also are intended to refer to multiple processors or computers. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing. Thus, references to a processor herein mean processing circuitry (e.g., circuitry that includes one or more processing element(s) circuits). One or more processors comprising processing circuitry also refers to each processor comprising processing circuitry, as well as some or all of the one or more processors comprising the same processing circuitry. In addition, processors(s) and controller(s), as a non-limiting example, do not mean human processing or human control, but rather, refer to hardware components as described herein, as non-limiting examples.

The methods illustrated in, and discussed with respect to, FIGS. 1-10 that perform the operations described in this application are performed by computing hardware, for example, by one or more processors or computers, implemented as described above implementing the instructions (e.g., computer or processor/processing device readable instructions) or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations. References to a processor, or one or more processors, as a non-limiting example, configured to perform two or more operations refers to a processor or two or more processors being configured to collectively perform all of the two or more operations, as well as a configuration with the two or more processors respectively performing any corresponding one of the two or more operations (e.g., with a respective one or more processors being configured to perform each of the two or more operations, or any respective combination of one or more processors being configured to perform any respective combination of the two or more operations). Likewise, a reference to a processor-implemented method is a reference to a method that is performed by one or more processors or other processing or computing hardware of a device or system.

The instructions or software to control computing hardware, for example, one or more processors or computers, to implement the hardware components and perform the methods as described above may be written as computer programs, code segments, or other executable instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. Thus, references herein to storage media mean storage media hardware, and does not mean to transitory media, nor a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive

(HDD), solid state drive (SSD), flash memory, a card type memory such as a multimedia card or a micro card (for example, secure digital (SD) or extreme digital (XD)), magnetic tapes, floppy disks, magneto-optical data storage devices, optical data storage devices, hard disks, solid-state disks, and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the disclosure is also inclusive of the claims.

## Claims

**1.** An electronic device comprising:

one or more processors including processing circuitry; and
memory including one or more storage media storing instructions,
wherein the instructions, when individually or collectively executed by the one or more processors, cause the electronic device to perform a process comprising:

receiving an input data stream;
loading a set of first elements among a set of elements of the input data stream to a first buffer;
generating one or more bit vectors based on a comparison between the set of first elements in the first buffer and a set of second elements in a second buffer among the set of elements of the input data stream;
determining a match length corresponding to a bit sequence that satisfies a determined match condition based on the one or more bit vectors;
determining a mismatch length corresponding to a bit sequence that satisfies a determined mismatch condition based on the one or more bit vectors; and
generating compressed data for the input data stream based on the match length and the mismatch length.

**2.** The electronic device of claim 1, wherein the generating of the compressed data for the input data stream comprises:

generating compression information based on the match length and the mismatch length; and
generating the compressed data for the input data stream based on the compression information.

**3.** The electronic device of claim 2, wherein the generating of the compression information comprises:

when the bit sequence that satisfies the determined match condition exists, determining a maximum length from match lengths determined based on the one or more bit vectors as the match length;
generating match information including the match length and a position in the second buffer corresponding to the match length; and
generating the compression information based at least on the match information.

**4.** The electronic device of claim 3, wherein, when a bit sequence of consecutive "1" bits corresponding to a depth of the first buffer exists in the one or more bit vectors, the match information further comprises an indicator of the bit sequence of consecutive "1" bits corresponding to the depth of the first buffer, or
wherein the generating of the compressed data for the input data stream based on the compression information comprises generating the compressed data by storing, in an output buffer, a literal string of the input data stream and a compression block including the match information, wherein the storing is performed according to a size of a reserved

space of the output buffer determined based on the match length.

**5.** The electronic device of claim 2, wherein the generating of the compression information comprises:

when the bit sequence that satisfies the determined match condition does not exist, determining a minimum mismatch length from mismatch lengths determined based on the one or more bit vectors;
generating mismatch information including the minimum mismatch length and one or more first elements of the first buffer corresponding to the minimum mismatch length; and
generating the compression information based at least on the mismatch information,
wherein the generating of the compressed data based on the compression information preferably comprises generating the compressed data by storing, through multi literal transfer, **MLT,** the one or more first elements of the first buffer corresponding to the minimum mismatch length in an output buffer as a literal string of a compression block.

**6.** The electronic device of one of claims 1 to 5, wherein the determined match condition comprises a bit sequence of at least one of the one or more bit vectors representing a number of consecutive "1" bits greater than or equal to a predefined threshold,
wherein the determining of the match length preferably comprises, when a bit sequence of consecutive "1" bits corresponding to a depth of the first buffer does not exist in the one or more bit vectors, determining a maximum length from lengths of bit sequences satisfying the determined match condition as the match length.

**7.** The electronic device of one of claims 1 to 6, wherein the determined mismatch condition comprises, in at least one of the one or more bit vectors, a bit sequence being a bit sequence before a predefined threshold number of consecutive "1" bits appear for a first time.

**8.** The electronic device of one of claims 1 to 7, wherein the generating of the one or more bit vectors comprises generating the one or more bit vectors based on the comparison between the set of first elements and the set of second elements by using a comparator chain comprised of XNOR gates.

**9.** The electronic device of one of claims 1 to 8, wherein the set of second elements of the second buffer includes at least some of elements that were previously processed among the set of elements of the input data stream.

**10.** A method performed by an electronic device, the method comprising:

receiving an input data stream;
loading a set of first elements among a set of elements of the input data stream to a first buffer;
generating one or more bit vectors based on a comparison between the set of first elements in the first buffer and a set of second elements in a second buffer among the set of elements of the input data stream;
determining a match length corresponding to a bit sequence that satisfies a determined match condition based on the one or more bit vectors;
determining a mismatch length corresponding to a bit sequence that satisfies a determined mismatch condition based on the one or more bit vectors; and
generating compressed data for the input data stream based on the match length and the mismatch length.

**11.** The method of claim 10, wherein the generating of the compressed data for the input data stream comprises:

generating compression information based on the match length and the mismatch length; and
generating the compressed data for the input data stream based on the compression information.

**12.** The method of claim 11, wherein the generating of the compression information comprises:

when the bit sequence that satisfies the determined match condition exists, determining a maximum length from match lengths determined based on the one or more bit vectors as the match length;
generating match information including the match length and a position in the second buffer corresponding to the match length; and
generating the compression information based at least on the match information,
wherein, when a bit sequence representing consecutive "1" bits corresponding to a depth of the first buffer exists in the one or more bit vectors, the match information further preferably comprises an indicator of the bit sequence

representing consecutive "1" bits corresponding to the depth of the first buffer.

**13.** The method of claim 11, wherein the generating of the compression information comprises:

when the bit sequence that satisfies the determined match condition does not exist, determining a minimum mismatch length from mismatch lengths determined based on the one or more bit vectors;
generating mismatch information including the minimum mismatch length and one or more first elements of the first buffer corresponding to the minimum mismatch length; and
generating the compression information based at least on the mismatch information.

**14.** The method of one of claims 10 to 13, wherein the determined match condition comprises a bit sequence of at least one of the one or more bit vectors representing a number of consecutive "1" bits greater than or equal to a predefined threshold,
wherein the determining of the match length preferably comprises when the bit sequence representing consecutive "1" bits corresponding to a depth of the first buffer does not exist in the one or more bit vectors, determining a maximum length from lengths of bit sequences satisfying the determined match condition as the match length.

**15.** A non-transitory computer-readable storage medium storing one or more programs including instructions, wherein the instructions, when individually or collectively executed by one or more processors of an electronic device, cause the electronic device to:

receive an input data stream,
load a set of first elements among a set of elements of the input data stream to a first buffer,
generate one or more bit vectors based on a comparison between the set of first elements in the first buffer and a set of second elements in a second buffer among the set of elements of the input data stream,
determine a match length corresponding to a bit sequence that satisfies a determined match condition based on the one or more bit vectors,
determine a mismatch length corresponding to a bit sequence that satisfies a determined mismatch condition based on the one or more bit vectors, and
generate compressed data for the input data stream based on the match length and the mismatch length.

100
Index
8b data
0 1 2 3 4 5 6 7 8 9 10 11 12 13 14 15 16 18 19 20 21 22 23 24 25 26 27 28 29 30
a b c d e f g a b c d e x y z e f g a b c d e m p b c d e f g
101
103
Scanned area 110
Scanning-in-progress area 120

FIG. 1

Header
Compressed data
200a
Block #1
Block #2
Block #3
· · ·
Block #N

FIG. 2A

Block #1
Block #2
Block #3
· · ·
Block #N
200b
Token
Literal
Match
1 Byte
Length 0-N bytes
Data 0-N bytes
Offset 2 bytes
Length 0-N bytes
201
203
205

FIG. 2B

300a
Search buffer (SB) 301
127 126 125 ... 112 111 110 ... 2 1 0
Look-ahead buffer (LB) 303
0
1
2
⋮
14
15
16
Comparator chain 305
Input data stream
Maximum match length selector 311
Literal
LB[0]
LZ4 block generator 309
LZ4 block

FIG. 3A

300b
Element pair (EP)
between LB and SB
LB [0]
307a
SB [127]
307b
LB [1]
SB [126]
LB [2]
SB [125]
...
LB [15]
SB [112]
XNOR
XNOR
XNOR
XNOR
Comp_chain [0]
0/1
Comp_chain [1]
0/1
Comp_chain [2]
0/1
...
Comp_chain [15]
0/1
Comparator chain
Comp_chain [15:0]

FIG. 3B

Search buffer (SB) 301
300c
127 126 125
...
112 111 110
...
2 1 0
Look-ahead buffer (LB) 303
0
1
2
14
15
Comparator chain 305
Input data stream
a b
...
c d e
...
Maximum match length selector 311
Match length
Position
Match length history table
Match len0<len, dist>
Match len1<len, dist>
Match len2<len, dist>
• • •
Longest consecutive match length
Match length
LZ4 block generator 309

FIG. 3C

Existing block layout 313
300d
Block 0
Block 1
Offset
T
L0
L1
Literal string
Offset
M0
T
L0
Literal string
M0
M1
. . .

FIG. 3D

400
Input memory
401
Processor
403
Compressor 405
Compression information generator 405a
First buffer
407
Second buffer
409
Comparator
chain
411
Maximum
match length
selector 413a
Minimum
mismatch length
selector 413b
Selection logic
415
Block generator
417
Output memory
419

FIG. 4

Start
510
Receive input data stream
520
Load set of first elements among set of elements of input data stream to first buffer
530
Generate one or more bit vectors based on comparison between set of first elements in first buffer and set of second elements in second buffer among set of elements of input data stream
540
Determine match length corresponding to bit sequence that satisfies determined match condition based on one or more bit vectors
550
Determine mismatch length corresponding to bit sequence that satisfies determined mismatch condition based on one or more bit vectors
560
Generate compressed data with respect to input data stream based on match length and mismatch length
End

FIG. 5

600
Search buffer (SB) 409
127 126 125
112 111 110
2 1 0
Look-ahead buffer (LB) 407
0
1
2
14
15
16
Comparator chain 411
a b c d e
Input data stream
Maximum match length selector 413a
Match length
Position
Literal
LB[0]
Block generator 417

FIG. 6

700a
Search buffer (SB) 409
127 126 125
112 111 110
2 1 0
Look-ahead buffer (LB) 407
0
1
2
14
15
Comparator chain 411
m a b n c d e
Input data stream
Maximum match length selector 413a
Match length
Position
Block generator 417

FIG. 7A

700b
Search buffer (SB) 409
127 126 125 ... 112 111 110 ... 2 1 0
Look-ahead buffer (LB) 407
0
1
2
14
15
Comparator chain 411
Input data stream
Minimum mismatch length selector 413b
Mismatch length
Literal 703
LB[0:15]
Block generator 417
Block

FIG. 7B

800
Search buffer (SB) 409
127 126 125
...
112 111 110
...
2 1 0
Broadcast to all first elements of first buffer
Look-ahead buffer (LB) 407
0
1
2
...
14
15
Comparator chain 411
Input data stream
LB[0:15]
Maximum match length selector 413a
Minimum mismatch length selector 413b
Match information {Match length, distance, indicator of maximum consecutive match}
Is_match found
Mismatch information {Match length, LB[0:15]}
415
0
Mux
1
Compression information
Block generator 417
Compression information:
i. match_flag
ii. match_info{match_len, location, is_cont_match} or
iii. mismmatch_info{mismatch_len, LB[0:15]}

FIG. 8

900a
Modified block layout 903
Block 0
Block 1
T
Literal string 1
L0
Literal string 2
L1
Literal string 3
Offset
M0
T
Literal string 1
L0
Literal string 2
Offset
M0
M1
...
15B
255B
255B
15B
255B

FIG. 9A

900b
MSB
OBUFF
LSB
Literal string 2
3
L0
4
Literal string 1
1
T
2
7
Offset
7
Literal string 3
5
L1
6
Literal string 2
3
Literal string 2
10
LO
11
Literal string 1
8
T
9
12
M0
7
M1
12
M0
12
Offset
12
Literal string 2
10

FIG. 9B

Electronic device 1000
At least one processor
1010
Memory
1020

FIG. 10

Europäisches
Patentamt
European
Patent Office
Office européen
des brevets

# EUROPEAN SEARCH REPORT

Application Number
EP 26 16 5716

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/089501 A1 (PATEL VINAY [CA]) 25 March 2021 (2021-03-25) | 1-4,6, 9-12,14, 15 | INV. H03M7/30 |
| Y | * abstract; claims; figures * | 8 | |
| A | * paragraphs [0021], [0026] - [0029], [0037], [0050] - [0056], [0074] - [0079] * | 5,7,13 | |
| Y | EP 1 729 422 A2 (KONINKL PHILIPS ELECTRONICS NV [NL]) 6 December 2006 (2006-12-06) * abstract; figures * * paragraphs [0010], [0019] - [0025], [0058] - [0069] * | 8 | |

TECHNICAL FIELDS SEARCHED (IPC)

H03M

The present search report has been drawn up for all claims

| Place of search | Date of completion of the search | Examiner |
|---|---|---|
| The Hague | 16 July 2026 | Scappazzoni, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................................
& : member of the same patent family, corresponding document

1
EPO FORM 1503 03.82 (P04C01)

## ANNEX TO THE EUROPEAN SEARCH REPORT ON EUROPEAN PATENT APPLICATION NO.

EP 26 16 5716

This annex lists the patent family members relating to the patent documents cited in the above-mentioned European search report. The members are as contained in the European Patent Office EDP file on
The European Patent Office is in no way liable for these particulars which are merely given for the purpose of information.

16-07-2026

| Patent document cited in search report | Publication date | Patent family member(s) | Publication date |
|---|---|---|---|
| US 2021089501 A1 | 25-03-2021 | CN 114450676 A | 06-05-2022 |
| | | EP 4035272 A1 | 03-08-2022 |
| | | JP 7732980 B2 | 02-09-2025 |
| | | JP 2022550042 A | 30-11-2022 |
| | | KR 20220073776 A | 03-06-2022 |
| | | US 2021089501 A1 | 25-03-2021 |
| | | WO 2021061608 A1 | 01-04-2021 |
| EP 1729422 A2 | 06-12-2006 | EP 1316154 A1 | 04-06-2003 |
| | | EP 1729422 A2 | 06-12-2006 |
| | | JP 2004507858 A | 11-03-2004 |
| | | KR 20030009313 A | 29-01-2003 |
| | | US 6348881 B1 | 19-02-2002 |
| | | WO 0219535 A1 | 07-03-2002 |

EPO FORM P0459

For more details about this annex : see Official Journal of the European Patent Office, No. 12/82